(19) Europäisches Patentamt / European Patent Office / Office européen des brevets

(11) **EP 2 387 295 A1**

(12) **EUROPEAN PATENT APPLICATION**

(43) Date of publication:
**16.11.2011 Bulletin 2011/46**

(51) Int Cl.:
*H05K 1/02* (2006.01)        *H01L 23/66* (2006.01)

(21) Application number: **10162427.8**

(22) Date of filing: **10.05.2010**

(84) Designated Contracting States:
**AL AT BE BG CH CY CZ DE DK EE ES FI FR GB GR HR HU IE IS IT LI LT LU LV MC MK MT NL NO PL PT RO SE SI SK SM TR**
Designated Extension States:
**BA ME RS**

(71) Applicant: **Dialog Semiconductor B.V.**
**5215 MV 's-Hertogenbosch (NL)**

(72) Inventors:
• **Colussi, Laurentius Cornelis**
  **3723 RC, Bilthoven (NL)**
• **Willms, Johannes Gerardus**
  **4907 MK, Oosterhout (NL)**

(74) Representative: **Ketelaars, Maarten F.J.M.**
**Nederlandsch Octrooibureau**
**J.W. Frisolaan 13**
**2517 JS  Den Haag (NL)**

(54)    **IC-Package with integrated impedance matching and harmonic suppression**

(57)    A package connected at a first side to a printed circuit board and with a die fixed to it on a second side opposite to the first side. The package has an integrated pre-match circuit (72) to provide an impedance match for a signal to be sent to a circuit (74) external to the package. The signal has a predetermined main frequency component. The pre-match circuit has a pair of transmission lines and a pair of stubs (2b1, 2b2) on a predetermined layer of the package and connected to the pair of transmission lines. The pair of stubs (2b1, 2b2) have a length such as to form a short circuit for an harmonic frequency of the main frequency component in the signal.

Fig 10

EP 2 387 295 A1

**Description**

**Field of the invention**

The present invention relates to the field of packages with integrated pre-match circuits.

**Background of the invention**

The main function of an integrated circuit (IC) package is to protect, power and cool an IC device within the package and provide thermal, electrical and mechanical connections to properly interface with a larger system such as a Printed Circuit Board (PCB).

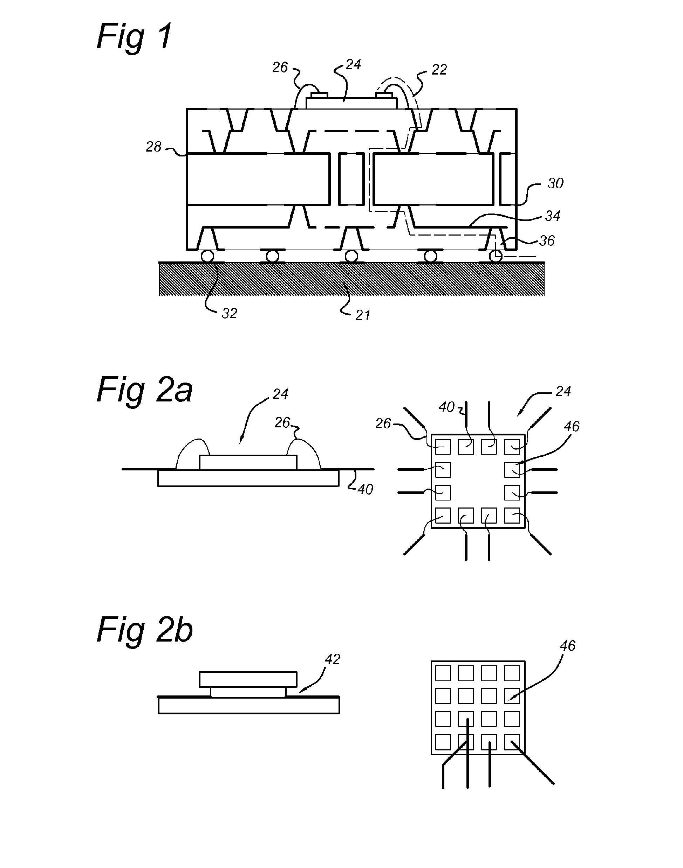

Figure 1 shows an example of such an IC package. The area on the bottom side of figure 1 is a PCB 21. On top of said PCB 21 an IC package is provided which comprises a plurality of connection points 32, one or more ground structures 28 which connect the package to ground, a power supply 30 which provides power to the package, a plurality of transmission lines 34 and one or more vias 36 inside of the package. A die 24 connects to the IC package via a plurality of bond wires 26. The IC package provides a signal path 22 (the dotted line depicted in figure 1) from the die 24 to a receiver circuit mounted on another area of the PCB 21.

The signal path 22 comprises: 1) a bonding structure from the die 24 to the bond wires 26 that act as an interface between the die 24 and the package, 2) transmission lines 34 which are inside of the package and 3) vias 36 in the right-bottom part of the figure 1 that provide one or more vertical connections to one or more connection points 32.

Normally the process of manufacturing an IC package comprises four main procedures:

1) A wafer is separated into IC chips (dies) by a diamond saw, normally this step is called a die separation step.

2) The separated die is bonded into the center of a lead frame or package, normally this step is called a die attachment step.

3) The pads on the IC chip and adjoining terminals on the lead frame are connected, one-by-one, with gold, copper or aluminum wires, normally this step is called a wire bonding step.

4) The chip is sealed with a macro-molecule plastic, like epoxy resin, thus finishing the plastic package container. The lead frame is cut, and leads are bent thus forming the package. This procedure is commonly called "Glob Top" assembly or encapsulation.

During the die attachment step, two different technologies may be used: a) wire bond attachment, and b) flip-chip attachment. Figure 2A describes the wire bond attachment and Figure 2B describes the flip-chip attachment in more detail.

The wire bond method described by Figure 2A is the most widely used method. The left side of Figure 2A is a side view of the wire bond method, the right side of Figure 2A is a top view of the wire bond method. The wire bond 26 is simply a very small wire with a diameter of about 0.0254 mm. The bond wire lengths vary from approximately 1.27 mm to 12.7 mm. The die 24 is mounted onto the package with a plurality of pads 46 on top. The bond wire 26 connects both the die 24 and a further pad 40 which is on the package. The advantage of the wire bond method is that it is inexpensive, mechanically simple, and allows for some changes in the bonding pad location and package routing. Furthermore, since the back of the die 24 is attached directly to the package substrate, it allows maximum surface area contact between the die and the package, which maximizes heat transfer out of the die 24.

The flip-chip attachment method described in Figure 2B is another widely used method. The left side of Figure 2B is a side view of the flip-chip attachment method, the right side of Figure 2B is a bottom view of the flip-chip attachment method. The die 24 is mounted onto the package with a plurality of package bond pads 46 on the bottom. A plurality of small solder balls 42 are located on pads of the die 24 in order to make a connection between the die 24 and the substrate. The die 24 is then placed upside down on the package and the solder is reflowed to make an electrical connection to the package bond pads 46. Flip-chip technology is also said to be self-aligning because when the solder is re-flowed, the surface tension of solder balls will pull the die 24 into alignment with the bond pads 46 on the package. The main advantage of flip-chip attachment is that the inductance of a flip-chip connection is much lower than that of a wire bond.

During the assembly procedure, two assembly technologies are mainly used: 1) Pin-through-hole (PTH) packaging, and 2) surface mount technology (SMT) packaging. If the packages have pins that can be inserted into holes in the PCB, the technology is called through-hole packaging. If the packages are not inserted into the PCB, but are mounted on the surface of the PCB, the technique is called SMT. The advantage of the SMT, as compared to PTH, is that both sides of the PCB can be used, and therefore, higher packing density can be achieved on the PCB.

Normally, an IC package may comprise a plurality of 1) vias and 2) stubs:

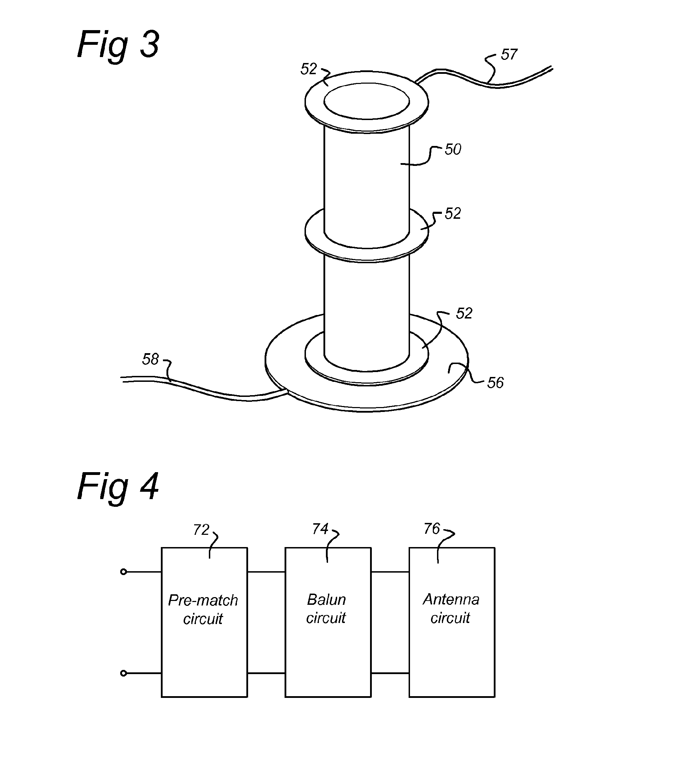

1) A via is a small hole drilled through a PCB that is arranged to make connections between various layers of the PCB or connect components to one or more leads (57, 58) on a layer of the PCB. The most common type of via is called a through-hole via because it is made by drilling a hole through the board, filling it with solder, and making connections on appropriate layers via a pad. Figure 3 shows the structure of a through-hole via. Normally a through-hole via comprises a barrel 50, one or more pads 52, and an antipad 56. As shown, the upper pad 52 connects to a lead 57 and antipad 56 connects to a lead 58 on a different layer.

2) A stub is a length of transmission line that is connected at one end only. The free end of the stub is either left open-circuited or short-circuited. Neglecting transmission line losses, the input impedance of the stub is purely reactive. Depending on the electrical length of the stub and on whether it is open or short circuit, the stub will perform either capacitively or inductively.

The interconnections in PCBs and in packages are generally considered as transmission lines. The transmission line can couple energy to adjacent signal lines, which results in crosstalk. Crosstalk can cause false switch of circuits and can increase delay times. Transmission lines account for a finite propagation velocity of electrical signals. The ratio of the voltage to the current carried by a wave in a particular direction on a transmission line is the characteristic impedance of the line. Discontinuities in the characteristic impedance cause partial reflections of the waves on the line. Reflections give rise to signals traveling the wrong way on an interconnect, which can be thought of as additional noise within the system. To prevent reflections, transmission lines must be properly terminated at their ends by "matching" the load impedance to the characteristic impedance of that line.

A balun circuit is a type of electrical transformer that converts signals that are balanced about ground to signals that are unbalanced and vice versa. The balun circuit is very often also used to change impedance. It can be simply considered as a transmission line transformer. In the area of the present invention where a chip could be connected to an antenna in order to transmit signals as generated on the chip, such a balun circuit is quite often used to connect the transmission line that is connected at one end to the chip at its other end to the antenna.

If the chip is bonded in a standard package via soldering iron (wire bond attachment), the larger the length of the associated transmission line, the worse the performance of the chip at the outside of the package will be. To counter this effect, a pre-match circuit 72 can be used between the transmission line and the balun circuit 74 which is, at its other end, connected to antenna circuit 76, as shown in figure 4.

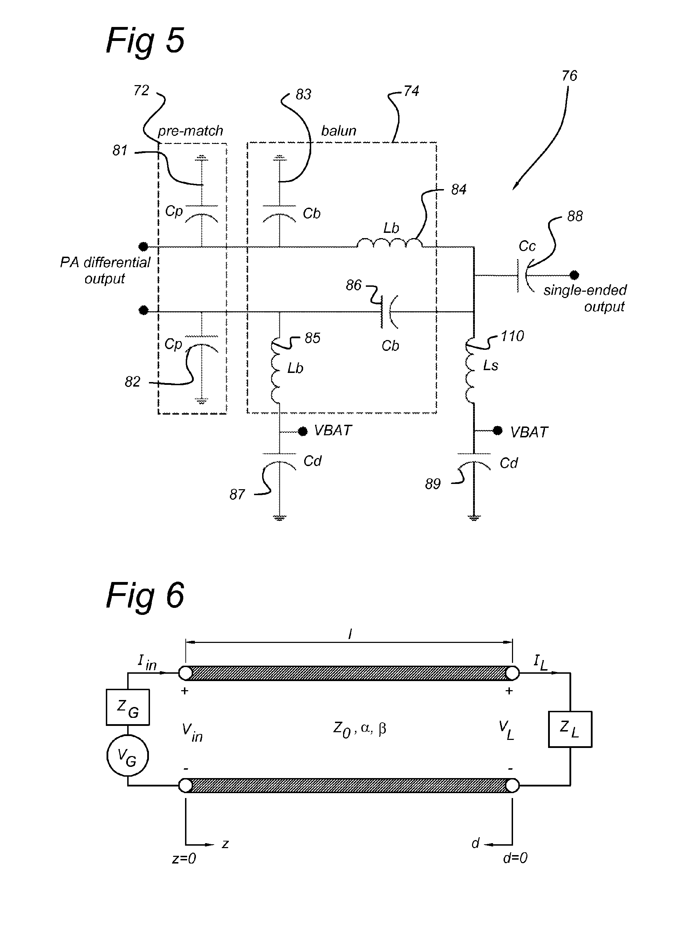

In the example of figure 5, the pre-match circuit 72 has two input lines connected to a differential output of the chip. One of the input lines is connected to ground via a capacitor 81. The other line is connected to ground via a capacitor 82. Both capacitors 81, 82 may have a value Cp. However, their values may be different. By doing so, the input lines to the pre-match circuit 72 may have a (very) low impedance whereas the output lines of the pre-match circuit 72 may have a (very) high impedance. Such a high impedance is easier to be dealt with by designers of balun circuits. In prior art arrangements, the pre-match circuit 72 is located on the die 24 or on the PCB.

The balun circuit 74 has two input lines connected to two output lines of the pre-match circuit 72. One of the input lines is connected to ground via a capacitor 83 and to an output line via an inductor 84. The other line is connected to a power supply VBAT via an inductor 85 and to another output line via a capacitor 86. Both capacitors 83, 86 may have a value Cb. However, their values may be different. Both inductors 84, 85 may have a value Lb. However, their values may be different. The power supply VBAT is connected to ground via a capacitor 87 which may have a value Cd.

Both output lines are short circuited and connected to ground via a series circuit of an inductor 110 having a value Ls and a capacitor 89 having a value Cd. Moreover, the short circuited output is connected to a single-ended output to be connected to an antenna via a capacitor 88 having a value Cc. The junction of inductor 110 and capacitor 89 is connected to power supply VBAT.

Inductors 85 and 110 are used to connect DC power supply VBAT to the balun circuit. Capacitors 87 and 89 are used for decoupling. Capacitor 88 is a coupling capacitor to the antenna. Capacitor 88 is not involved in the matching function.

In general the output of the chip is connected to the pre-match circuit 72 by means of a transmission line. However, the pre-match circuit 72 between the chip and the balun circuit 74 which connects to the antenna may not be close enough to the chip outputs. Due to this relatively long transmission line the (very) low impedance at the chip output transforms to a impedance with a high quality (Q) factor. This makes the pre-match circuit 72 and balun circuit 74 more sensitive for component value variations of the various inductors and capacitors in these circuits.

To solve this pre-match circuit problem, one existing solution is called "Known Good Die" (KGB). In this solution, the package is entirely removed and the chip is assembled on the Printed Circuit Board (PCB) directly close to pre-match circuit 72. The disadvantage of the KGB solution is that this assembly technique is not supported by all manufacturers since many of them prefer packaged chips. Moreover, it is more difficult to test a chip without package.

Another known solution is called "low-temperature co-fired ceramic" (LTCC): Here, the chip is assembled on a substrate which contains the pre-match circuit 72. Subsequently, the substrate is bonded on a PCB. The pre-match circuit can exist both as a planar structure on the assembled component and as a circuit incorporated on the substrate. The disadvantage of LTCC is that the cost is very high.

The present invention uses a pre-match circuit integrated in a package. Pre-match circuits integrated in a package are, for instance, known from US2008/191362, US2004/178854, and US 6 215 377. However, such pre-match circuits may suffer from transmission of radiation at higher harmonics of signals within the pre-match circuit.

**Summary of the invention**

The object of the invention is to provide a package with integrated pre-match circuit that solves the impedance matching problem between a package and printed circuit board (PCB). Moreover, an object is to solve problems relating to transmission of radiation relating to higher harmonics of signals within the pre-match circuit.

The object is solved by a package as defined in claim 1. By integrating the pre-match circuit in the package, the impedance matching can be realized close to the chip outputs, while still having the benefits of using a package. Moreover, by designing the first pair of stubs to have a length such as to substantially form a short circuit for at least one harmonic frequency of the main frequency component in the signal, this harmonic frequency will not give rise to external radiation.

Other aspects of the invention are claimed in other independent claims.

Advantageous embodiments are claimed in dependent claims.

**Brief description of the drawings**

The invention will be explained in detail with reference to some drawings that are only intended to show embodiments of the invention and not to limit the scope. The scope of the invention is defined in the annexed claims and by its technical equivalents.

The drawings show:

Figure 1 shows some signal paths within a known IC packaging.

Figures 2A and 2B, respectively, show a prior art wire bond attachment technique and flip-chip attachment technique, respectively.

Figure 3 is an example of a prior art through-hole via.

Figure 4 shows a block diagram of pre-match circuit and balun circuit.

Figure 5 shows an electrical diagram example of pre-match circuit and balun circuit.

Figure 6 shows a transmission line with arbitrary termination $Z_L$.

Figure 7 shows a normalized input susceptance versus $\beta l$ for an open-circuited, lossless transmission line.

Figure 8 shows a first layer of a package according to the invention.

Figure 9 shows a second layer of a package according to the invention.

Figure 10 shows a third layer of a package according to the invention.

Figure 11 shows a fourth layer of a package according to the invention.

Figure 12 shows a cross section diagram of a package according to the invention.

Figure 13 shows a cross section diagram of a package according to the invention.

Figure 14 shows a cross section diagram of a package according to the invention.

Figure 15 shows a cross section diagram of a package according to the invention.

Figure 16 shows a third layer of a package according to the invention.

Figure 17 shows a cross section diagram of a package according to the invention.

Figure 18 shows a first layer of a package according to the invention.

Figure 19 shows a second layer of a package according to the invention.

Figure 20 shows a third layer of a package according to the invention.

Figure 21 shows a fourth layer of a package according to the invention.

Figure 22 shows a cross section diagram of a package according to the invention.

**Detailed description of embodiments**

Now it will be explained how, in the present invention, the problems of the prior art are overcome by having the pre-match circuit implemented as an integrated impedance matching circuit inside the package.

Figure 6 shows a representation of a transmission line with a characteristic impedance $Z_0$, an attenuation constant $\alpha$ and a phase constant $\beta$. At its input side, the transmission line is connected to a voltage source $V_G$ having an internal impedance of $Z_G$. The distance z is the distance along the transmission line, starting from the voltage source $V_G$. The transmission line is terminated with a load impedance $Z_L$. A voltage across the load impedance $Z_L$ is indicated with $V_L$. The distance $d$ is the distance along the transmission line, starting from the load impedance $Z_L$. The total length of the transmission line is $l$.

It can be derived that the reflection coefficient at an arbitrary point $d$ on the line is:

$$\Gamma = \Gamma_L \, e^{-2\gamma d} \qquad (1)$$

With

$$\Gamma_L = \frac{Z_L - Z_0}{Z_L + Z_0} \qquad (2)$$

and

$$\gamma = \alpha + j\beta \qquad (3)$$

Since the reflection coefficient is related to the impedances $Z_0$ and $Z_L$ via equation (2), it is apparent that the impedance must also be a function of position:

$$Z = Z_0 \frac{1+\Gamma}{1-\Gamma} = Z_0 \frac{1+\Gamma_L \, e^{-2\gamma d}}{1-\Gamma_L \, e^{-2\gamma d}} \qquad (4)$$

where Z represents the impedance at a certain point along the line at position $d$. Introducing equation (2) and making use of the following hyperbolic equation

$$\tanh z \equiv \frac{\sinh z}{\cosh z} = \frac{e^z - e^{-z}}{e^z + e^{-z}} \qquad (5)$$

equation (4) can be rewritten into the following relation:

$$Z = Z_0 \frac{Z_L + Z_0 \tanh \gamma d}{Z_0 + Z_L \tanh \gamma d} \qquad (6)$$

The input impedance is obtained by merely setting $d = l$.

In many practical situations, the line attenuation can be neglected and hence it is useful to write equation (6) for the lossless case. For $\alpha = 0$, $\gamma d = j\beta d$ and $tanh\ \gamma d$ becomes $j\ tan\ \beta d$. For a lossless line, equation (6) can be rewritten as follows:

$$Z = Z_0 \frac{Z_L + jZ_0 \tan \beta d}{Z_0 + jZ_L \tan \beta d} \qquad (7)$$

In figure 6, a special case of the transmission line is the open-circuited line with $Z_L = \infty$. Introducing this information in equation (7) gives the input impedance of this open-circuited line:

$$Z_{in} = -jZ_0 \cot \beta l \qquad (8)$$

The input admittance is given by the following relation:

$$Y_{in} = \frac{1}{Z_{in}} = jB_{in} = jY_0 \tan \beta l \qquad (9)$$

with

$$Y_0 = \frac{1}{Z_0} \qquad (10)$$

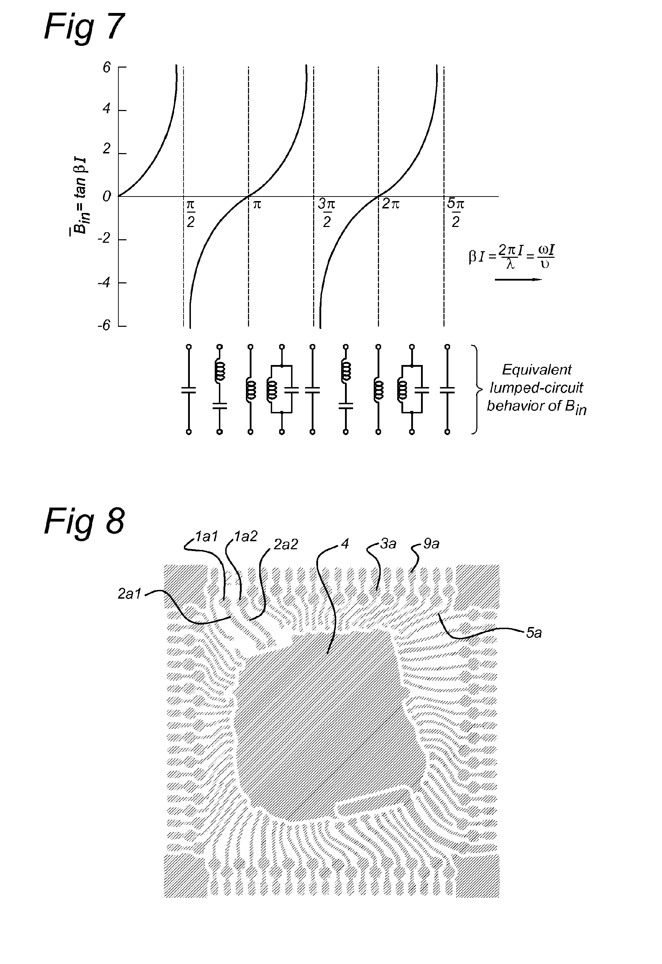

A plot of the normalized input susceptance $\tan \beta l$ versus $\beta l = 2\pi l/\lambda$ is the tangent function and is given in figure 7.

For $\beta l < \pi/2\ (l < \lambda/4)$, the input is capacitive since $B_{in}$ is positive. Thus $B_{in} = \omega C_{eq}$ and

$$C_{eq} = \frac{Y_0}{\omega} \tan \beta l \qquad farads \qquad (11)$$

with

$$\omega = 2\pi f \qquad\qquad (12)$$

This capacitive behaviour of the transmission line is used for the pre-matching at the DECT frequencies. When $\beta l = \pi/2$ ($l = \lambda/4$), $B_{in}$ equals $\infty$, which means that the input of the transmission line is shorted. This behaviour can be used to short the unwanted 2nd harmonic signals that pass through the pre-matching circuit towards the balun circuit 74 on the external PCB.

In accordance with the invention, by changing the properties of the transmission line ($Z_0$, length, shape, coupling with ground layers, etc) the transmission line(s) are configured in such a way that the required pre-matching capacitance together with the short at the 2nd harmonic frequency is obtained. The transmission line(s) can even be used in combination with a ground layer that is not placed on the inside or outside of the package. In that case, the transmission lines can be placed on the outside of the package, while the ground layer on the PCB underneath the package acts as a ground layer for the transmission lines.

As is shown in figure 7, we can deduce the following equivalences:

1. At frequencies in the vicinity of $\beta l = (2n-1)\pi/2$ (an odd number of quarter wavelengths), the open-circuited line behaves like a short.
2. At frequencies in the vicinity of $\beta l = n\pi$ (an integral number of halve wavelengths), the open-circuited line behaves like an open.

By looking at figure 7 and taking into account point 2 as mentioned above, we can notify that the transmission line also behaves like a short at the 6th harmonic frequency ($\beta l = 3\pi/2$). At the 4th harmonic frequency ($\beta l = \pi$), the input of the transmission line behaves like an open. This is unwanted because this creates a sensitive node for any unwanted signals at the 4th harmonic frequency.

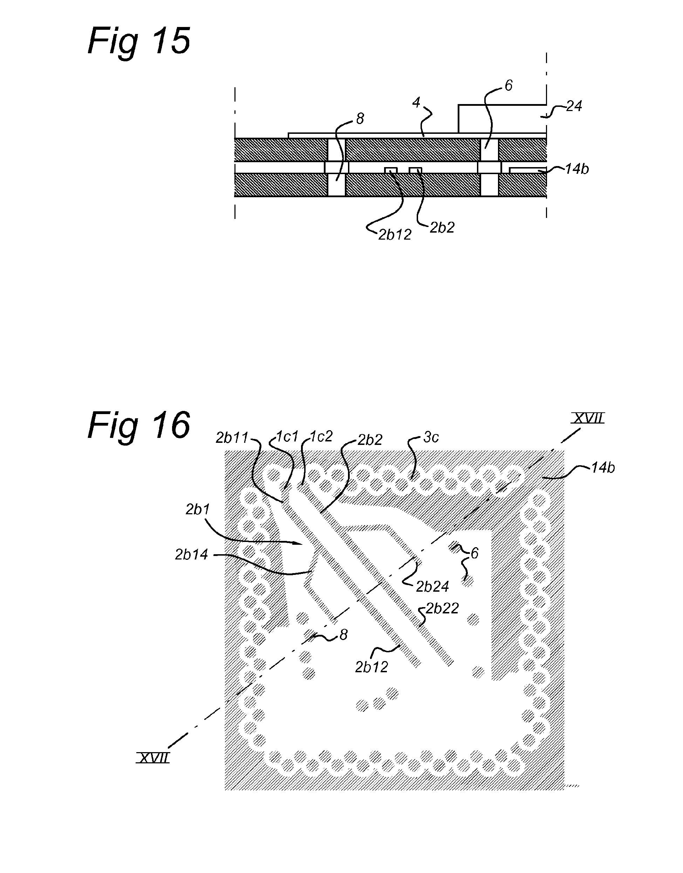

This behaviour of the transmission line can be extended for the other harmonic frequencies such as, for example, the 3rd ($\beta l = 3\pi/4$) and 5th ($\beta l = 5\pi/4$) harmonic. As can be seen in figure 7, the input impedance at these frequencies is neither a short nor an open. By adding multiple open-circuited or even short-circuited transmission lines to the already present transmission line, the behaviour of the 3rd and 5th harmonic can also be controlled. Also an additional open-circuited transmission line for the 4th harmonic can be added to compensate for the unwanted effect of the original transmission line ($\beta l = \pi$). An example of such a multiple open-circuited transmission line layout is explained with reference to figure 16 below.

A first embodiment of the package relates to a substrate of four-layers and will be explained with reference to figures 8 to 11. It is observed that the invention is not restricted to substrates with four layers. This package may be manufactured by a Surface Mount Technology (SMT) or wire bond attachment technology. As a standard package, all four layers have the same dimension. As will be explained below, the four-layer package contains one or more stubs and a plurality of through-hole vias which together provide the same impedance as a pre-match circuit as shown in figure 5, i.e. the pre-match circuit is moved into the package. The balun circuit remains external (on main PCB).

As shown in the drawing of figure 8, the first layer of the package comprises two through-hole vias 1a1 and 1a2 on the upper-left part of figure 8. The through-hole vias 1a1, 1a2 are connected to two short transmission lines 2a1 and 2a2, respectively. The first layer comprises a big die attachment area 4 in the center where, in use, the chip (not shown in figure 8) is attached. Moreover, the first layer comprises a plurality of pads 9a consecutively located on the edge of figure 8, a plurality of through-hole vias 3a consecutively located close to said pads 9a, a plurality of conducting leads 5a. Each lead 5a connects to both one pad 9a and one through-hole via 3a. Wire bonds 26 (depicted in figure 1) may be used to connect stubs 2a1, 2a2 and the die attached above said attachment area 4.

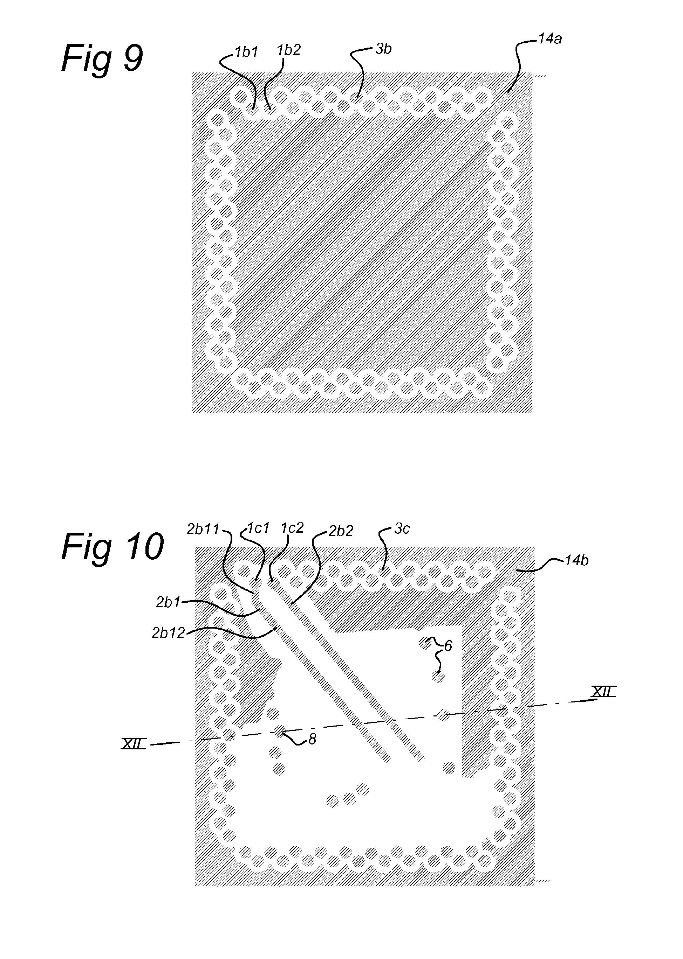

As shown in the drawing of figure 9, the second layer of the package comprises two through-hole vias 1b1 and 1b2 on the left part of figure 9. The through-hole vias 1b1 and 1b2 have exactly the same dimensions as the through-hole vias 1a1, 1a2 in the first layer, and when the first layer is located on top of the second layer the through-hole vias 1a1, 1a2 are exactly located above (aligned with) the through-hole vias 1b1, 1b2, respectively. Moreover, the second layer comprises a ground structure 14a which covers most of the remaining area of the second layer apart from a plurality of through-hole vias 3b. These through-hole vias 3b have the same dimensions as through-hole vias 3a in the first layer (see figure 8) and will be aligned with through-hole vias 3a when the second layer is located on top of the first layer.

As shown in the drawing of figure 10, the third layer of the package comprises a pair of stubs 2b1 and 2b2. The stub 2b1 comprises a long portion 2b12 and a short portion 2b11. The long portion 2b12 and the stub 2b2 are located on a central, non-conductive area of the third layer. The lengths of the stub 2b1 and 2b2 are substantially the same. The lengths of the stubs 2b1 and 2b2 equal one fourth of the wavelength $\lambda$ ($\lambda$ /4) of the signal transmitted from the die to the balun circuit 74 in order to short the unwanted second harmonic components of this signal as mentioned before. Also the 6th, 10th, etc. harmonic components may be shorted in this way as explained with reference to figure 7.

The third layer comprises three through-hole vias 1c1, 1c2. The through-hole vias 1c1, 1c2 have such dimensions and are arranged on such locations that they will be aligned with through-hole vias 1a1 and 1a2, 1b1 and 1b2, respectively, when the first and second layers are located on top of the third layer. The short portion 2b11 of stub 2b1 is connected to the through-hole via 1c1 and the stub 2b2 is connected to the through-hole via 1c2. Moreover, the third layer comprises a plurality of through-hole vias 6, 8 which are located on the edge of the central, non-conductive area of the third layer. The third layer also has a plurality of through-hole vias 3c which are dimensioned and located to be aligned with through-hole vias 3b on the second layer when the first and second layers are located on top of the third layer.

Both said stubs 2b1 and 2b2, and said vias 6, 8 are located inside of the same area as die attachment area 4 depicted in figure 8.

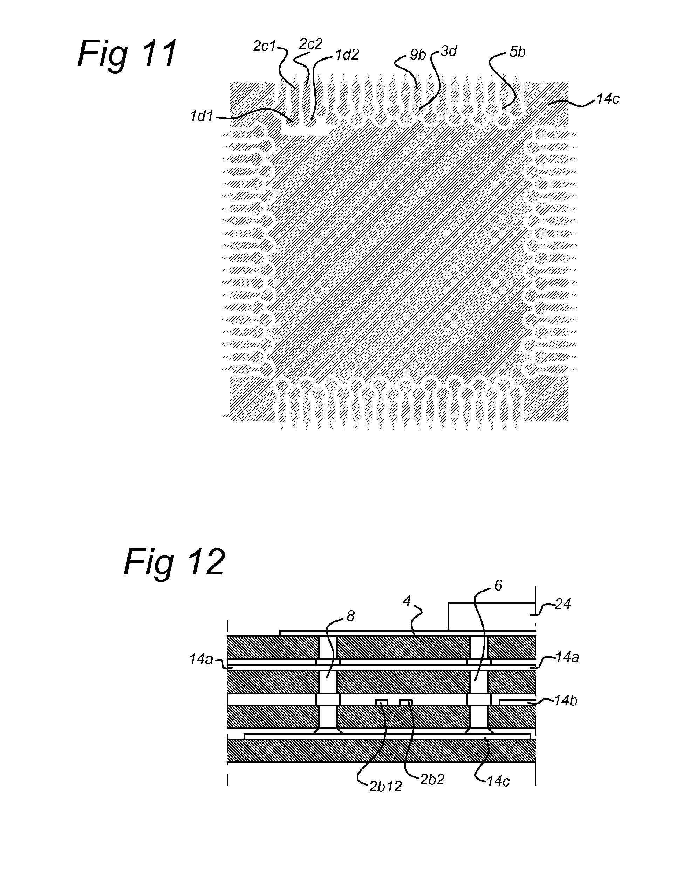

As shown in the drawing of figure 11, the fourth layer of the package comprises two conductive pads 1d1 and 1d2 on the upper-left part of the figure. The conductive pads 1d1 and 1d2, respectively, are located and arranged such that, when the first, second and third layers are located on top of the fourth layer, they connect to the through-hole vias 1c1 and 1c2, respectively. They are also connected to two short transmission lines 2c1 and 2c2, respectively, on the fourth layer that, on their other sides, are connected to suitable pads on the edge of the fourth layer. The two short transmission lines 2c1 and 2c2 are arranged such that, when the first, second and third layers are located on top of the fourth layer, they are aligned with the short transmission lines 2a1 and 2a2, respectively.

The fourth layer comprises a plurality of conductive pads 3d that are located such that they are aligned with and connected to through-hole vias 3c in the third layer when the first, second and third layers are located on top of the fourth layer. The pads 3d are connected to suitable conductive leads 5b on the fourth layer that connect to a suitable pads 9b at the edge of the fourth layer. The fourth layer comprises a ground structure area 14c that substantially covers the remaining part of the area of the fourth layer. When the first, second and third layers are located on top of the fourth layer, the through-hole vias 6 in the third layer connect to the ground structure area 14c.

The drawing of figure 12 shows how the four layers are located relative to one another when they are located on top of one another. Figure 12 is a cross section along line XII-XII indicated in figure 10.

By this arrangement, stub 2b1, together with transmission lines 2a1 and 2c1 act as one unified structure. Moreover, stub 2b2, together with transmission lines 2a2 and 2c2, act as another unified structure. Both structures together provide the output of the die with the same impedance value as the pre-match circuit 72 that is depicted in figure 5.

The through-hole vias 6, 8 penetrate the package from the die attachment area 4 on the first layer to the fourth layer and is arranged to connect to the ground structure 14a on the second layer and to the ground structure 14c on the fourth layer. The aim of the through-hole via 6 is to electrically connect the die attachment area 4 to the ground structures 14a, and 14c. Moreover, ground structure 14b is grounded too via one or more suitable through holes (not shown). The distances between the ground structures 14a, 14b and 14c, respectively, and the two structures are well defined. So, both unified structures together have a capacity against these ground structures 14a, 14b and 14c which is well defined and can be estimated very well in advance.

A second embodiment of the package relates to a substrate of three-layers and will be explained with reference to figures 8,10 and 11.

In the second embodiment of the package, the first layer is the same as the first layer of the first embodiment depicted in figure 8. The second layer of the second embodiment is the same as the third layer of the first embodiment depicted in figure 10. The third layer of the second embodiment is the same as the fourth layer of the first embodiment depicted in figure 11.

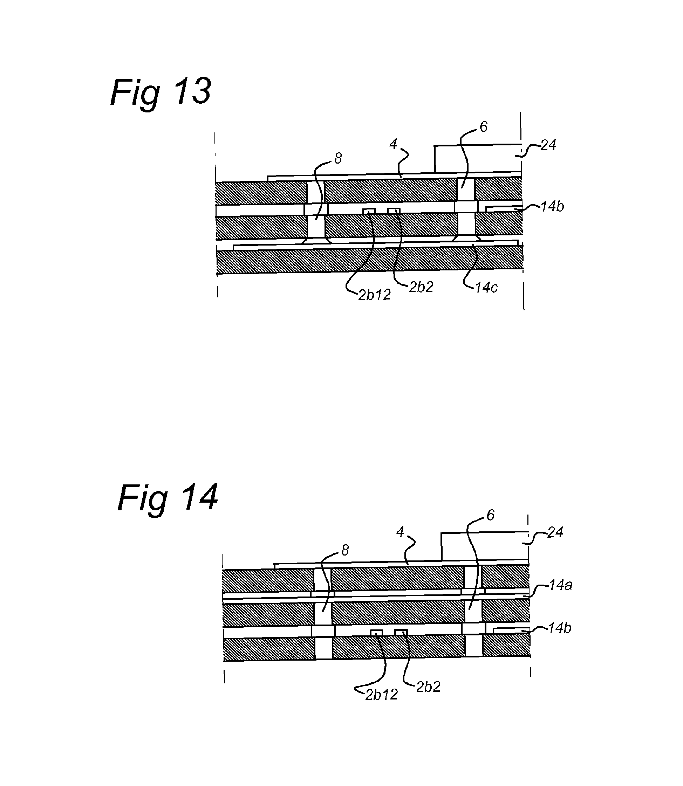

The drawing of figure 13 shows how, in the second embodiment, the three layers are located relative to one another when they are located on top of one another. Figure 13 is a cross section along line XII-XII indicated in figure 10 for the second embodiment.

By this arrangement, stub 2b1, together with transmission lines 2a1 and 2c1 act as one unified structure. Moreover, stub 2b2, together with transmission lines 2a2 and 2c2, act as another unified structure. Both structures together provide the output of the die with the same impedance value as the pre-match circuit 72 that is depicted in figure 5.

The through-hole vias 6, 8 now penetrate the package from die attachment area 4 on the first layer to the second and third layer and is arranged to connect die attachment area 4 on the first layer to the ground structure 14c on the third layer. The aim of the through-hole via 6 is to electrically connect die attachment area 4 on the first layer to the ground structure 14c. Moreover, ground structure 14b is grounded too via one or more suitable through holes (not shown). The distances between the first layer and the ground structures 14b and 14c, respectively, and the two structures are well defined. So, both unified structures together have a capacity against die attachment area 4 on the first layer and the ground structures 14b and 14c which are well defined and can be estimated very well in advance.

A third embodiment of the package relates to a substrate of three-layers and will be explained with reference to figures 8, 9, 10 and 14.

In the third embodiment of the package, the first layer is the same as the first layer of the first embodiment depicted in figure 8. The second layer of the third embodiment is same as the second layer of the first embodiment depicted in figure 9. The third layer of the third embodiment is same as the third layer of the first embodiment depicted in figure 10.

The drawing of figure 14 shows how the three layer are located relative to one another when they are located on top of one another. Figure 14 is a cross section along line XII-XII indicated in figure 10 for the third embodiment.

By this arrangement, transmission line 2a1 and stub 2b1 act as one unified structure. Moreover, transmission line 2a2 and stub 2b2 act as another unified structure. Both unified structures together provide the output of the die with the same impedance value as the pre-match circuit 72 that is depicted in figure 5.

The through-holes via 6, 8 penetrate the package from the die attachment area 4 on the first layer to the ground structure 14a to the bottom side of the third layer and is arranged to connect the first layer to the bottom of the third layer. The aim of the through-hole vias 6, 8 is to electrically connect the die attachment area 4 to the ground structure 14a and to the bottom of the third layer where it can be connected to a ground layer on the PCB. Moreover, ground structure 14b is grounded too via one or more suitable through holes (not shown). The distances between the ground structures 14a, 14b and the ground layer on PCB below the third layer, respectively, and the two unified structures are well defined. So, both the unified structures together have a capacity against the ground structures 14a, 14b and the ground layer on the PCB which are well defined and can be estimated very well in advance.

A fourth embodiment of the package relates to a substrate of two-layers and will be explained with reference to figures 8, 10 and 15.

In the fourth embodiment of the package, the first layer is the same as the first layer of the first embodiment depicted in figure 8. The second layer of the fourth embodiment is the same as the third layer of the first embodiment depicted in figure 10.

The drawing of figure 15 shows how the two layers are located relative to one another when they are located on top of one another. Figure 15 is a cross section along line XI-XI indicated in figure 10 for the fourth embodiment.

By this arrangement, transmission line 2a1 and stub 2b1 act as one unified structure. Moreover, transmission line 2a2 and stub 2b2 act as another unified structure. Both unified structures together provide the output of the die with the same impedance value as the pre-match circuit 72 that is depicted in figure 5.

The through-hole vias 6, 8 are arranged to electrically connect the die attachment layer 4 to a ground layer on the PCB such that they are both grounded. Moreover, ground structure 14b is grounded too via one or more suitable through holes (not shown). The distances between the die attachment layer 4 and ground layer on PCB, respectively, and the two unified structures are well defined. So, both unified structures together have a capacity against the die attachment area 4, the ground structure 14b and the ground layer on the PCB which are well defined and can be estimated very well in advance.

A fifth embodiment of the package relates to a substrate of four-layers and will be explained with reference to figure 8, 9, 11 and 16. It is observed that this embodiment is not restricted to substrates with four layers. As a standard package, all four layers have the same dimension. As will be explained below, the four-layer package contains one or more stubs and a plurality of through-hole vias which together provide the same impedance as a pre-match circuit as shown in figure 4, i.e. the pre-match circuit 72 is moved into package. The balun circuit 74 remains external (on main PCB).

In the fifth embodiment, the first layer is the same as the first layer of the first embodiment depicted in figure 8. The second layer of the fifth embodiment is the same as the second layer of the first embodiment depicted in figure 9. The fourth layer of the fifth embodiment is the same as the fourth layer of the first embodiment depicted in figure 11. Figure 16 shows the third layer of the fifth embodiment. As shown in the drawing of figure 16, the third layer of the package comprises a pair of stubs 2b1 and 2b2. The stub 2b1 comprises a long portion 2b12, a short portion 2b11, and an extended portion 2b 14 extending from the long portion 2b12. The stub 2b2 comprises a long portion 2b22, and an extended portion 2b24 extending from long portion 2b22. The stubs 2b1 and 2b2 are located on a central, non-conductive area of the third layer, respectively. The length of the long portion 2b22 equals the length of the short portion 2b1 together with long portion 2b12 of stub 2b1 which is one fourth of the wave length $\lambda$ *($\lambda$ /4)*.

The lengths of extended portions 2b14 of stub 2b1 and 2b24 of stub 2b2 are substantially the same. Their lengths are selected such as to short a certain further predetermined harmonic component of the signal. For instance, the lengths of 2b11+2b12 and of 2b22 are chosen such as to form a short for the second harmonic frequency at the location of vias 1c1 and 1c2, as explained above. The extended portions 2b14 and 2b24 have respective lengths that are selected such that together with the lengths of the portions of subs 2b1 and 2b2, respectively connecting the extending portions 2b14 and 2b24, respectively, to vias 1c1 and 1c2, respectively, form a short for the fourth (or other higher) harmonic at the locations of the vias 1c1 and 1c2.

Available parameters for achieving both goals of providing a desired capacity for the pre-match circuit and of providing a short circuit for one or more higher harmonics are the length and width of 2b1 and 2b2, and, if present, of 2b14 and 2b24, respectively. Also the mutual couplings, i.e. mutual distances, between the different stubs 2b1 / 2b2, 2b12 / 2b22 and between the stubs and the extended portions, so 2b14 / 2b12, 2b24 / 2b22 and between the stubs and extended portions and the ground planes (could be ground planes 14a, 14b or 14c or any combination thereof) can be used as a design parameter. For instance, extended portions 2b14 and 2b24 can be arranged such that they are substantially at an angle of 90 ° to each other and 45° to stubs 2b1 and 2b2, such they their mutual coupling to the stubs is negligible.

All the other features of layer three of the fifth embodiment as shown in figure 16 are the same as those of the third layer shown in figure 10.

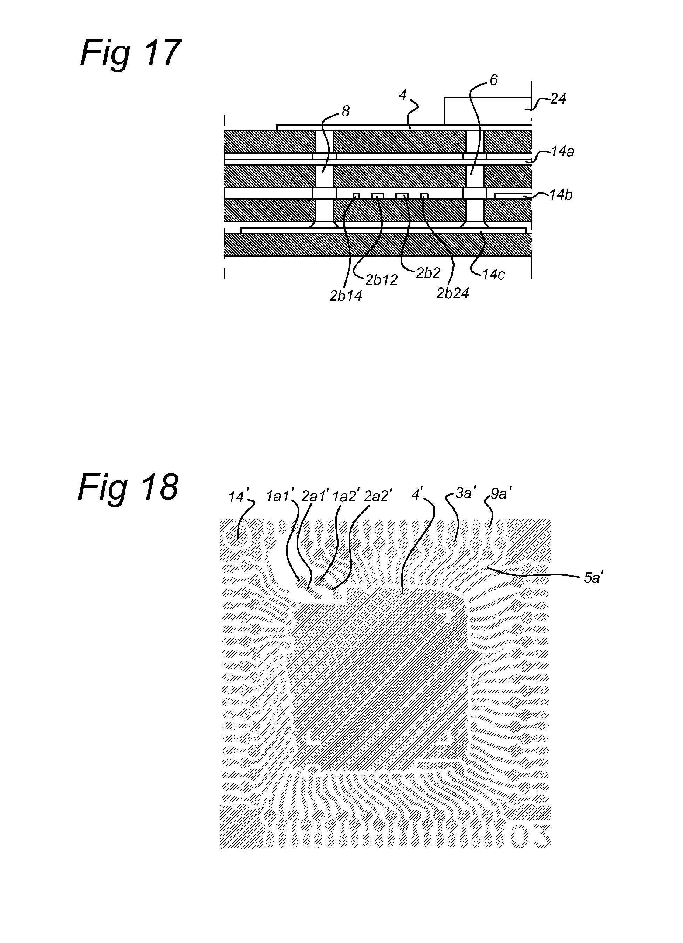

The drawing of figure 17 shows how the four layers are located relative to one another when they are located on top of one another. Figure 17 is a cross section along line XVII-XVII indicated in figure 16. The cross section is essentially the same as the one shown in figure 12, apart from the extended portions 2b14 and 2b24, respectively, on the third layer.

A sixth embodiment of the new package relates to a substrate of four-layers and will be explained with reference to figure 18-21. It is observed that this embodiment is not restricted to substrates with four layers. This package may use Surface Mount Technology (SMT) and wire bond attachment technology. As a standard package, all four layers have the same dimension. As will be explained below, the four-layer package contains one or more stubs and a plurality of through-hole vias which together provide the same impedance as a pre-match circuit 72 as shown in figure 5, i.e. the pre-match circuit 72 is moved into package. The balun circuit 74 remains external to the package but on main PCB.

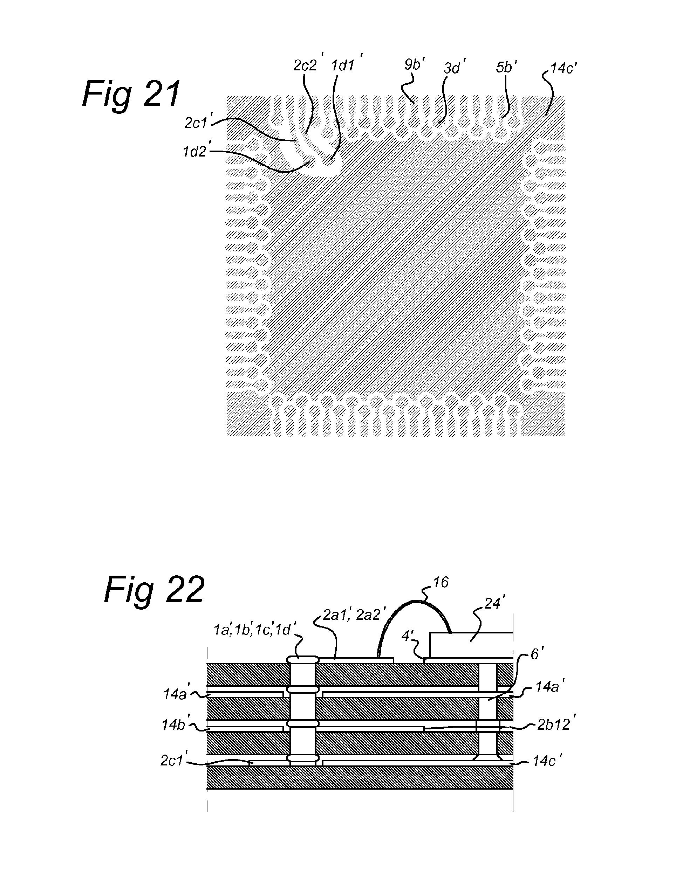

As shown in the drawing of figure 18, the first layer of the package comprises two through-hole vias 1a1' and 1a2' on the upper-left part of figure 18. These through-hole vias 1a1', 1a2' are connected to two short transmission lines 2a1' and 2a2', respectively. The first layer comprises a big die attachment area 4' in the center where the chip (not shown in figure 18) is attached. Moreover, the first layer comprises a plurality of pads 9a' consecutively located on the edges of figure 18, a plurality of through-hole vias 3a' consecutively located close to said pads 9a', a pad 14' in the form of a circle located on the upper-left of figure 18 which is used as ground structure and connects to other ground structures (14a', 14b', 14c') on other layers by a through-hole via (not shown), a plurality of conducting leads 5a'. Each lead 5a' connects to both one pad 9a' and one through-hole via 3a'. Two wire bonds 16 (depicted in figure 22) are provided which connect to both said stubs 2a1' and 2a2' and the die attached above said attachment area 4'.

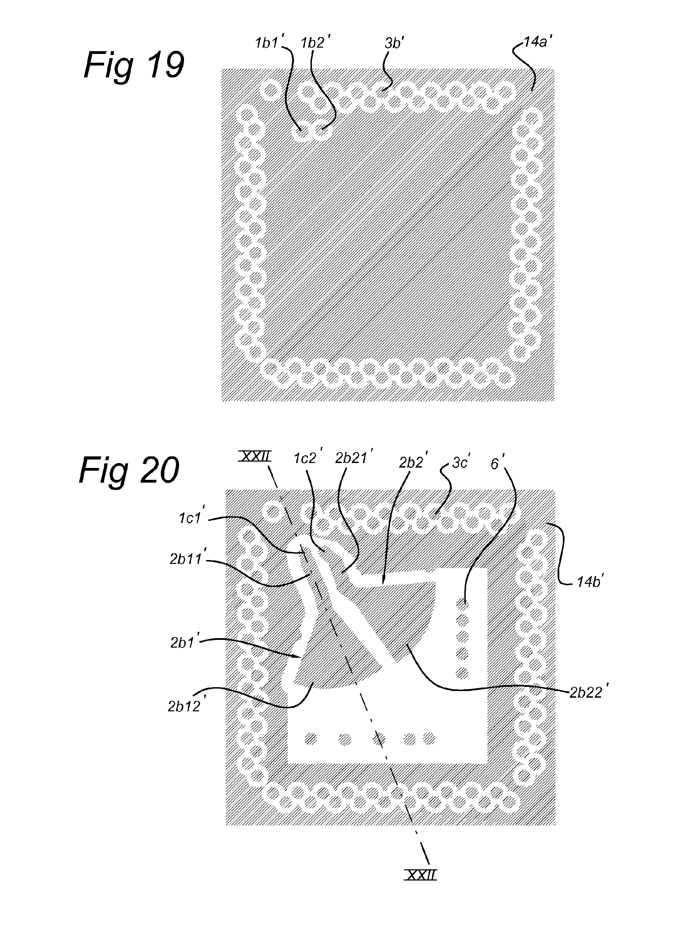

As shown in the drawing of figure 19, the second layer of the package comprises two through-hole vias 1b1' and 1b2'. These two through-hole vias 1b1' and 1b2' have exactly the same dimensions as the two through-holes 1a1', 1a2' in the first layer, and when the first layer is located on top of the second layer the through-holes 1a1', 1a2' are exactly located above 1b1', 1b2', respectively. Moreover, the second layer comprises a ground structure 14a' which covers most of the remaining area of the second layer apart from a plurality of through-holes 3b'. These through-holes 3b' have the same dimensions as through-holes 3a' in the first layer (see figure 18) and will be aligned with through-holes 3a' when the second layer is located on top of the first layer.

As shown in the drawing of figure 20, the third layer of the package comprises two stubs 2b1' and 2b2'. Each of these stubs 2b1' and 2b2', respectively, comprise a short bar shaped area, 2b11' and 2b21', respectively. These bar shaped areas 2b11' and 2b21' may be aligned with the locations of stubs 2a1' and 2a2', respectively, on the first layer depicted in figure 18. The stubs 2b1' and 2b2', respectively, also comprise fan-shaped areas 2b12' and 2b22', respectively, which may be as large as one eighth of a circle area with a diameter of approximately 7mm. The third layer comprises two through-hole vias 1c1' and 1c2' which have such dimensions and are arranged on such locations that they will be aligned with through-holes 1a1' and 1a2', 1b1' and 1b2', respectively, when the first and second layers are located on top of the third layer. Moreover, the third layer comprises a plurality of through-hole vias 6' which are symmetrically located on the edge of a central, non-conductive area of the third layer. The third layer also has a plurality of through-hole vias 3c' which are dimensioned and located to be aligned with through-hole vias 3b' on the second layer when the first and second layer are located on top of the third layer. Both said stubs 2b1' and 2b2', and said vias 6 are located inside of the same area as die attachment area 4 depicted in figure 18. The third layer also comprises a ground structure 14b' which is located on the edge of figure 20.

As shown in the drawing of figure 21, the fourth layer of the package comprises two conductive pads 1d1' and 1d2' on the upper-left part of the figure. The conductive pads 1d1' and 1d2', respectively are located and arranged such that, when the first, second and third layers are located on top of the fourth layer, they connect to the through-hole vias 1c1' and 1c2', respectively. They are also connected to two short transmission lines 2c1' and 2c2', respectively, on the fourth layer that, on their other sides, are connected to suitable pads on the edge of the fourth layer. The two short transmission lines 2c1' and 2c2' are arranged such that, when the first, second and third layers are located on top of the fourth layer, they are aligned with the short transmission lines 1a1' and 1a2', respectively. The fourth layer comprises a plurality of conductive pads 3d' that are located such that they are aligned with and connected to through-holes 3c' in the third layer when the first, second and third layer are located on top of the fourth layer. The pads 3d' are connected to suitable conductive leads 5b' on the fourth layer that connect to suitable pads 9b' at the edge of the fourth layer. The fourth layer comprises a ground structure area 14c' that substantially covers the remaining part of the area of the fourth layer. When the first, second and third layers are located on top of the fourth layer, the through-hole vias 6' in the third layer connect to the ground structure area 14c'.

The drawing of figure 22 shows how the four layer are located relative to one another when they are located on top of one another. Figure 22 is a cross section along line XXII-XXII indicated in figure 20.

As shown in the drawing of figure 22, the through-hole vias 1a1', 1b1', 1c1' penetrate across the upper three layers where the first layer is the top layer and the fourth layer is the bottom layer. The last through-hole via 1c1' connects to pad 1d1' on the fourth layer. The through-hole vias 1a1', 1c1', 1d1', respectively, are attached to transmission line 2a1', stub 2b1' and transmission line 2c1', respectively.

The through-hole vias 1a2', 1b2', 1c2' also penetrate across the upper three layers. The last through-hole via 1c2' connects to pad 1d2' on the fourth layer. The through-hole vias 1a2', 1c2', 1d2', respectively, are attached to transmission line 2a2', stub 2b2', and transmission line 2c2', respectively.

By this arrangement, stubs 2b1', transmission lines 2a1' and 2c1' act as one unified structure. Moreover, stubs 2b2', transmission lines 2a2' and 2c2' act as another unified structure. Both structures together provide the output of the die with the same impedance value as the pre-match circuit 72 that is depicted in figure 5.

The through-hole via 6' penetrates the PCB from the first layer to the fourth layer and is arranged to electrically connect the ground structure 14a' on the second layer to the ground structure 14c' on the fourth layer. The distances between the ground structures 14', 14a', 14b' and 14c', respectively, and the fan shaped stubs 2b12', 2b22' are well defined. So, the two unified structures together have a capacity against these ground structures 14', 14a', 14b' and 14c' which is well defined and can be estimated very well in advance. Moreover, when two such ground structures are provided on opposing sides of the fan-shaped stubs 2b12', 2b22' they provide a cage of Faraday to the stubs, thus protecting from external electromagnetic radiation.

The fan shaped structure can be combined with any one of the embodiments of the figures 8-17.

**Claims**

1. A package to be connected at a first side to a printed circuit board and arranged to have a die fixed to it on a second side opposite to the first side, the package having an integrated pre-match circuit (72) to provide an impedance match for a signal to be sent to a circuit (74) external to the package, the signal having a predetermined main frequency component, the pre-match circuit comprising a pair of transmission lines and a first pair of stubs (2b1, 2b2) arranged on a predetermined layer of the package and connected to said pair of transmission lines, wherein the first pair of stubs (2b1, 2b2) have a length such as to substantially form a short circuit for at least an harmonic frequency of the main frequency component in the signal, said harmonic frequency being higher than the main frequency itself.

2. A package according to claim 1, wherein the harmonic frequency is the second harmonic frequency of the main frequency.

3. A package according to claim 2, wherein the pre-match circuit comprises at least a second pair of stubs (2b14, 2b24) having dimensions such as to substantially form a short circuit for at least one other harmonic frequency of the main frequency component in the signal, the other harmonic frequency being higher than the second harmonic frequency.

4. A package according to any of the preceding claims, wherein the package comprises a first ground layer on top of the predetermined layer.

5. A package according to any of the preceding claims, wherein the package comprises a second ground layer below the predetermined layer.

6. A package to be connected at a first side to a printed circuit board and arranged to have a die fixed to it on a second side opposite to the first side, the package having an integrated pre-match circuit (72) to provide an impedance match for a signal to be sent to a circuit (74) external to the package, the signal having a predetermined main frequency component, the pre-match circuit comprising a pair of transmission lines and a first pair of stubs (2b1, 2b2) arranged on a predetermined layer of the package and connected to said pair of transmission lines, wherein the first pair of stubs (2b1, 2b2) have a fan shape.

7. A printed circuit board having a package according to any of the preceding claims attached to it, as well as a circuit (74), the circuit being electrically connected to the pre-match circuit (72) integrated in the package.

8. A printed circuit board according to claim 8, wherein the circuit is a balun circuit (74).

*Fig 1*

*Fig 2a*

*Fig 2b*

Fig 3

57

52

50

52

58

52

56

Fig 4

72

74

76

Pre-match circuit

Balun circuit

Antenna circuit

## Fig 5

## Fig 6

## Fig 7

$$\beta I = \frac{2\pi I}{\lambda} = \frac{\omega I}{\upsilon}$$

Equivalent lumped-circuit behavior of $B_{in}$

## Fig 8

**Fig 9**

**Fig 10**

Fig 11

Fig 12

## Fig 13

## Fig 14

*Fig 15*

*Fig 16*

## Fig 17

## Fig 18

Fig 19

Fig 20

Fig 21

Fig 22

Europäisches
Patentamt

European
Patent Office

Office européen
des brevets

## EUROPEAN SEARCH REPORT

**Application Number**

EP 10 16 2427

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2004/178854 A1 (INOUE AKIRA [JP] ET AL) 16 September 2004 (2004-09-16) | 6-8 | INV.<br>H05K1/02<br>H01L23/66 |
| Y | * paragraphs [0031] - [0041]; figures 1-3 * | 1-5 | |
| Y | US 2008/315392 A1 (FARRELL DONALD [US] ET AL) 25 December 2008 (2008-12-25) * paragraphs [0003], [0008], [0038], [0054]; figures 2G,9B * | 1-5 | |
| A | US 2005/151599 A1 (IDO TATEMI [JP] ET AL) 14 July 2005 (2005-07-14) * paragraphs [0037] - [0050]; figures 1,2 * | 1,6 | |
| A | US 2009/212879 A1 (ROFOUGARAN AHMADREZA [US]) 27 August 2009 (2009-08-27) * paragraphs [0028] - [0044]; figures 2,4 * | 1,6 | |

TECHNICAL FIELDS
SEARCHED      (IPC)

H01L
H01P
H03F
H05K

The present search report has been drawn up for all claims

| Place of search | Date of completion of the search | Examiner |
|---|---|---|
| The Hague | 22 September 2010 | Degroote, Bart |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

**ANNEX TO THE EUROPEAN SEARCH REPORT
ON EUROPEAN PATENT APPLICATION NO.**

EP 10 16 2427

This annex lists the patent family members relating to the patent documents cited in the above-mentioned European search report.
The members are as contained in the European Patent Office EDP file on
The European Patent Office is in no way liable for these particulars which are merely given for the purpose of information.

22-09-2010

| Patent document cited in search report | | Publication date | Patent family member(s) | | Publication date |
|---|---|---|---|---|---|
| US 2004178854 | A1 | 16-09-2004 | CN | 1531194 A | 22-09-2004 |
| | | | DE | 102004011719 A1 | 09-12-2004 |
| | | | JP | 4012840 B2 | 21-11-2007 |
| | | | JP | 2004281625 A | 07-10-2004 |
| US 2008315392 | A1 | 25-12-2008 | CN | 101785110 A | 21-07-2010 |
| | | | EP | 2162914 A2 | 17-03-2010 |
| | | | KR | 20100024496 A | 05-03-2010 |
| | | | WO | 2009002387 A2 | 31-12-2008 |
| US 2005151599 | A1 | 14-07-2005 | CN | 1638117 A | 13-07-2005 |
| | | | JP | 2005198051 A | 21-07-2005 |
| US 2009212879 | A1 | 27-08-2009 | NONE | | |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2008191362 A
- US 2004178854 A

- US 6215377 B